# EUROPEAN PATENT SPECIFICATION

(11) **EP 3 795 724 B1**
(45) Date of publication and mention of the grant of the patent: **20.11.2024**
(21) Application number: 19198772.6
(22) Date of filing: 20.09.2019
(51) Int. Cl.: C30B 29/04, C30B 33/12, G03F 7/00, G03F 7/075, G03F 7/11, G03F 7/16, G03F 7/40

(54) **MICRO AND NANO STRUCTURING OF A DIAMOND SUBSTRATE**
MIKRO- UND NANOSTRUKTURIERUNG EINES DIAMANTSUBSTRATS
STRUCTURATION MICRO ET NANO D'UN SUBSTRAT DE DIAMANT

(43) Date of publication of application: 24.03.2021
(73) Proprietor: Universität des Saarlandes, 66123 Saarbrücken (DE)
(72) Inventor: RADTKE, Mariusz, 60320 Frankfurt am Main (DE); NEU-RUFFING, Elke Katja, 66450 Bexbach (DE); SLABLAB, Abdallah, 93120 La Courneuve (FR)
(74) Representative: Lecomte & Partners

(56) References cited:
- WO-A1-2019/043570
- RICHARD R GROTE ET AL: "Imaging a Nitrogen-Vacancy Center with a Diamond Immersion Metalens", ARXIV.ORG, CORNELL UNIVERSITY LIBRARY, 201 OLIN LIBRARY CORNELL UNIVERSITY ITHACA, NY 14853, 2 November 2017 (2017-11-02), XP081444763, DOI: 10.1038/S41467-019-10238-5
- PLISKIN ET AL: "Silicon Dioxide Step Gauge", IP.COM JOURNAL, IP.COM INC., WEST HENRIETTA, NY, US, 1 March 1963 (1963-03-01), XP013085032, ISSN: 1533-0001
- SPIE, PO BOX 10 BELLINGHAM WA 98227-0010 USA, 2005, XP040211998
- ZHANG ZHIQIANG ET AL: "Improving the adhesion of hydrogen silsesquioxane (HSQ) onto various substrates for electron-beam lithography by surface chemical modification", MICROELECTRONIC ENGINEERING, vol. 128, 5 October 2014 (2014-10-05) - 5 October 2014 (2014-10-05), pages 59 - 65, XP029038038, ISSN: 0167-9317, DOI: 10.1016/J.MEE.2014.05.027

## Description

### Technical field

The invention is directed to the field of micro- and nano-structuring a substrate, in particular a diamond substrate.

### Background art

A perfect diamond is transparent. What gives it colour are atomic sized defects in the lattices structure induced e.g. by electron irradiation, ion implantation or growth, aptly called colour centres. A colour centre is a type of crystallographic point defect which consists of lattice vacancies, carbon interstitials, impurity atoms or a small complex of these components. Colour centres tightly bind one or more electrons. Electrons bound to colour centres tend to absorb light in the visible spectrum such that a material that is usually transparent becomes coloured.

Such colour centres often possess electronic and nuclear spin, which provide degrees of freedom that can be controlled by microwave and radiofrequency electromagnetic fields. For several colour centres, spin states can be read out optically, i.e. with the help of visible light. Thanks to the remarkably long coherence times of electron and nuclear spins in diamond they are excellent candidates for the realization of quantum information processing, quantum simulation and quantum sensing.

Creating colour centres in diamond typically involves bombardment using non-carbon impurity ions (ion implantation) to introduce colour centres or irradiation e.g. with highly energetic electrons which knock carbon atoms out of the diamond lattice and thus create vacancies. Annealing as an additional step may induce the formation of complexes with vacancies. The latter can especially be active impurities in the diamond to form complexes with vacancies. The most commonly used fluorescent colour centres within diamond are nitrogen and silicon vacancies

For photonic applications of diamond nanostructures, controlling the geometrical shape of the nanostructures as well as their surface quality is crucial. Photonic nanostructure solves a main issue of light extraction from colour centres in diamond i.e. the fact that photon extraction efficiency for fluorescent colour centres in unstructured diamond does not exceed a few percent due to internal reflection of light. Forming nanopillars with tailored geometry considerably enhances the photoluminescence rates. The structuring (etching) plasma must be specially adapted in order to obtain the desired nanostructure shape as well as smooth surfaces avoiding light scattering.

The most accessible tool to most researchers in industry and academia for producing nano- or micro-structures is electron beam lithography (EBL), which allows control of written structures down to 10 nanometres in size. EBL requires conductive samples, which makes it non-practicable to structure insulating diamond. Also, as diamond is composed in bulk of sp³ hybridized carbon atoms, it is chemically inert and requires etching with high power plasmas (often using oxygen). Diamond shows variously terminated surfaces (e.g. hydrogen, carboxyl, carbonyl, groups), which have to be removed by harsh chemical washing methods using acids such as Piranha solution. In addition to these difficulties, the masking of the diamond is even more challenging. Most photoresists or electron beam resists provide a poor etching selectivity to diamond, which forbids the formation of diamond nano- or microstructures using known methods. In contrast, etch resistant hydrogen silsesquioxane resists adhere only moderately to diamond reducing reliability of nanofabrication processes.

A E Grigorescu and C W Hagen, "Resists for sub-20-nm electron beam lithography with a focus on HSQ: state of the art", Published 1 July 2009 IOP Publishing Ltd, Nanotechnology, Volume 20, Number 29, provides a review of the electron beam lithography (EBL) for nano-structuring with a focus on hydrogen silsesquioxane HSQ as electron beam resist. The achievement of sub-20-nm structures using EBL is a very sensitive process determined by various factors, starting with the choice of resist material. To obtain finer patterns, improvements of the material properties of the resist are very important. A relatively new e-beam resist, HSQ, is very suitable when aiming for sub-20-nm resolution. The changes that this resist undergoes before, during and after electron beam exposure are discussed and the influence of various parameters (e.g. pre-baking, exposure dose, writing strategy, development process) on the resolution is presented. More specifically, in section 3.2 spin coating of resist on a substrate is discussed. Accordingly, the adhesion strength between the surfaces is determined both by the formation of chemical bonds between the surfaces, and the surface roughness. With regard to diamond substrates, a good adhesion of HSQ is suggested.

In contrast, P. Appel, E. Neu, M. Ganzhorn, A. Barfuss, M. Batzer, M. Gratz, A. Tschöpe and P. Maletinsky, "Fabrication of all diamond scanning probes for nanoscale magnetometry", Review of Scientific Instruments, 87, 063703, 2016, points to the necessity of an adhesion layer between HSQ and smooth diamond surfaces. In detail, it discusses the structuring of diamonds by induction coupled plasma reactive-ion etching through a HSQ structuring mask that is coated via a titanium adhesion layer. Although the titanium layer shows a good adhesion on the diamond it shows as drawback that it rapidly oxidises when in contact with ambient air, leading to poor adhesion of the HSQ resist if the adhesion layer is oxidized. Another drawback is that the titanium adhesion layer is removed chemically, i.e. by immersion in an HCl solution. This can damage the areas of the adhesion layer that are below the structuring mask and potentially lead to a separation of the mask. Furthermore, the chemical removal of the titanium layer can contaminate the diamond by residual titanium, which generates additional noise when reading out the colour centres, imposing poor quality to the diamond structures for sensing applications.

Lillie, Scott E.; Broadway, David A.; Dontschuk, Nikolai; Zavabeti, Ali; Simpson, David A.; Teraji, Tokuyuki; Daeneke, Torben; Hollenberg, Lloyd C. L.; Tetienne, Jean-Philippe, "Magnetic noise from ultrathin abrasively deposited materials on diamond", Physical Review Materials, Volume 2, Issue 11, id.116002, 8 November 2018, discusses the magnetic noise that metallic materials can have when deposited on a diamond. Ultrathin layers, i.e. with a thickness of less than 1nm, of metallic material such as Fe, Cu, Cr and Au, abrasively deposited on a diamond give rise to a broadband source of noise.

Wi J S, Lee T Y, Jin K B, Hong D H, Shin K H and Kim K B 2006, "Electron-beam lithography of Co/Pd multilayer with hydrogen silsesquioxane and amorphous Si intermediate layer", J. Vac. Sci. Technol. B 24, 2616, cited as reference [69] in the above preceding publication, teaches the use of an amorphous silicon layer for enhancing adhesion of HSQ on a Cu/Pd multilayer. In that reference, the silicon layer is believed to well adhere on magnetic layers because its surface energy is lower than half of most transition metals.

RICHARD R GROTE ET AL, "Imaging a Nitrogen-Vacancy Center with a Diamond Immersion Metalens", ARXIV.ORG, CORNELL UNIVERSITY LIBRARY, 201 OLIN LIBRARY CORNELL UNIVERSITY ITHACA, NY 14853, (20171102), doi:10.1038/S41467-019-10238-5, discloses a process of structuring a diamond substrate according to the preamble of claim 1, for forming a metalens.

WO 2019/043570 A1 discloses a process of structuring a diamond substrate for forming Diffractive Optical Elements.

PLISKIN ET AL, "Silicon Dioxide Step Gauge", IP.COM JOURNAL, IP.COM INC., WEST HENRIETTA, NY, US, (19630301), ISSN 1533-0001, discloses a step-wise etching process.

D.J. WAGNER, A.H. JAYATISSA, "Nanoimprint lithography: Review of aspects and applications", SPIE, PO BOX 10 BELLINGHAM WA 98227-0010 USA, (2005), pages 60020R1 - 60020R10, discloses a review of aspects and applications in nanoimprint lithography.

### Summary of invention

### Technical Problem

The invention has for technical problem to overcome at least one drawback of the above cited prior art. More specifically, the invention has for technical problem to improve micro- and nano-structuring of diamond substrates.

### Technical solution

The invention is directed to a process of structuring a diamond substrate, comprising the steps of: (a) depositing an adhesion layer on a face of the diamond substrate; (b) coating a resist layer on the adhesion layer; (c) removing parts of the resist layer so as to expose parts of the adhesion layer and form a corresponding structuring mask; (d) etching the adhesion layer and the diamond substrate through the structuring mask so as to form structures on the face of said diamond substrate; wherein the adhesion layer comprises substantially a non-metallic compound; and wherein at least one of the structures comprise one or more colour centres.

Advantageously, the non-metallic compound corresponds, in weight, to at least 80%, preferably at least 90%, of the adhesion layer.

Advantageously, the adhesion layer is the non-metallic compound.

Advantageously the diamond substrate is a single crystal diamond.

Advantageously the diamond substrate comprises one or more colour centres. The one or more colour centres are adjacent to the face that is structured.

Advantageously the oxides in the adhesion layer concentrate towards the diamond substrate.

Advantageously, before step (a), the diamond substrate is cleaned by immersion in acid(s) for removing a possible graphitic layer on the face to be structured and possibly oxidizing said layer.

According to a preferred embodiment, the non-metallic compound comprises at least one of the following list: silicon, silicon oxide, germanium and germanium oxide, or any combination thereof.

According to a preferred embodiment, at step (a) the adhesion layer is deposited by electron beam physical vapour deposition, plasma activated chemical vapour deposition, thermal deposition or atomic layer deposition.

According to a preferred embodiment, the adhesion layer extends homogeneously over the whole face of the diamond substrate, preferably with a thickness of at least 1nm and/or of not more than 200 nm, preferably at least 10nm and/or not more than 50nm.

According to a preferred embodiment, step (d) comprises the following sub-steps: (d1) etching the adhesion layer through the structuring mask so as to expose parts of the diamond substrate; and (d2) etching the diamond substrate through the structuring mask so as to structure said diamond substrate.

According to a preferred embodiment, steps (d1) and (d2) are achieved by plasma, preferably with reactive gases, preferably in the same plasma installation.

According to a preferred embodiment, the reactive gases in step (d1) is fluorine-based and/or the reactive gas in step (d2) is oxygen based.

According to a preferred embodiment, the resist layer is an electron beam resist layer or a photo resist layer and step (c) is achieved by electron beam lithography or optical lithography, and subsequent development of the resist.

According to a preferred embodiment, the resist layer comprises a silsesquioxane, preferably Hydrogen silsesquioxane HSQ.

According to a preferred embodiment, the process comprises the further step of: (e1) removing the structuring mask and the adhering layer that remains further to step (d).

According to a preferred embodiment, the process comprises the further steps of: (e2) removing the structuring mask so that the adhesion layer remains on the structure; (f) coating a further resist layer on the adhesion layer remaining on the structure; (g) removing parts of the further resist layer so as to expose parts of the adhesion layer on the structure and form a further structuring mask; (h) etching the further adhesion layer and the diamond substrate through the further structuring mask so as to further structure the structure of said diamond substrate.

According to a preferred embodiment, step (h) comprises the following sub-steps: (h1) etching the further adhesion layer through the further structuring mask so as to expose parts of the structure of the diamond substrate; and (h2) etching the diamond substrate through the further structuring mask so as to further structure said diamond substrate.

According to a preferred embodiment, step (e1) or (e2) is achieved by wet etching.

According to a preferred embodiment, the structuring comprises structures with a height of at least 1nm, preferably at least 200 nm, and/or of not more than 10 000 nm, preferably not more than 500nm.

According to a preferred embodiment, at least one of the structures comprise nitrogen-vacancy centres.

The above steps (a) to (h) are carried out successively according to the alphabetical order of their letters and numerical order of their numbers.

### Advantages of the invention

The invention is particularly interesting in that it provides a good adhesion of the resist layer on diamond while avoiding the drawbacks of metallic adhesion layers as in the prior art, i.e. rapid oxidation leading to poor adhesion when the resist layer is not coated rapidly, potentially pollution of the surface of the diamond hosting nearby colour centres, and removal by chemical etching that potentially damages the structuring mask. This leads to a higher accuracy and conformity of the structuring and in parallel to a more flexible process, i.e. with less constraints.

### Brief description of the drawings

Figure 1 illustrates a step of depositing an adhesion layer on a diamond substrate by electron beam physical vapour deposition.
Figure 2 illustrates a step of spin coating a resist layer on the adhesion layer of the diamond substrate, deposited as in figure 1.
Figure 3 illustrates a step of electron beam lithography on the resist layer coated as in figure 2.
Figure 4 illustrates the diamond substrate after removal of areas of the resist layer that have not been subject to the electron beam lithography as in figure 2, so as to form a structuring mask.
Figure 5 illustrates a step of structuring by plasma etching the adhesion layer and the diamond substrate.
Figure 6 illustrates a step of removing the structuring mask and the adhesion layer after structuring in figure 5.
Figure 7 illustrates an alternative step to removing the structuring mask and adhesion layer as in figure 6, consisting in removing the structuring mask only.
Figure 8 illustrates a step of spin coating a further resist layer on the diamond substrate.
Figure 9 illustrates a step of electron beam lithography on the further resist layer coated in figure 8.
Figure 10 illustrates a step of removing areas of the further resist layer that have not been subject to the electron beam lithography as in figure 9, so as to form a further structuring mask.
Figure 11 illustrates a step of further structuring by plasma etching the further adhesion layer and the diamond substrate.

### Description of an embodiment

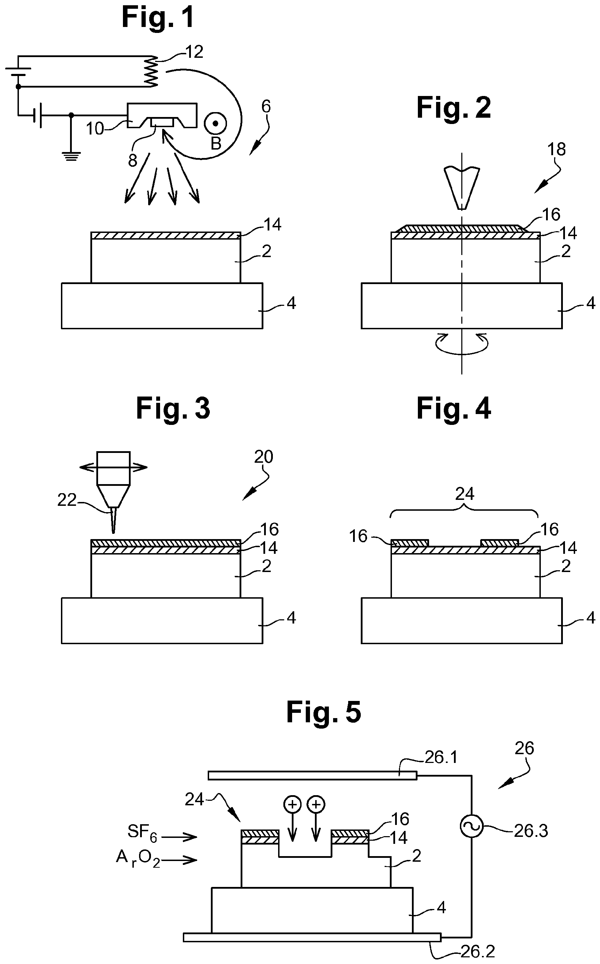

Figures 1 to 5 illustrate successive steps of a process of structuring a diamond substrate according to the invention. In the context of this invention, structuring means providing a structured surface on a face of the diamond substrate. The structured surface is obtained for instance by removing material of the diamond substrate so as to form various shapes like pillars, wires, cantilevers or disks. These shapes can be in the micro-scale and/or in the nano-scale.

The structuring process of the diamond substrate consists essentially in coating a resist layer on a face of the diamond substrate, removing parts of the resist layer for forming a structuring mask, and etching the diamond substrate through the structuring mask. To that end, the structuring mask made of the resist layer must properly adhere to the diamond structure. Etching of diamond requires however high-energy and/or oxygen plasmas which under certain circumstances require specific resits that might not properly adhere to the diamond substrate. The invention provides depositing an adhesion layer on the diamond substrate before coating the resist layer. The adhesion layer is made of a non-metallic compound and comprises oxides. Metallic compounds tend indeed to oxidize rapidly in contact with ambient air, showing thereby poor adhesion properties with the resist layer. Oxides of non-metallic compound are at the contrary formed during deposition and provide a good adhesion to the diamond substrate.

Before structuring the diamond substrate, the later can be cleaned, for instance mechanically and/or chemically. Mechanical cleaning can comprise rubbing with a wipe wetter with solvent, dipping in a solvent like acetone, ultrasound bath and drying. Chemical cleaning can comprise immersion in acid, preferably a mixture of 3 acids HNO₃, H₂SO₄ and HClO₄. The acid mixture can be heated during immersion until it changes colour from transparent to yellow, corresponding to the production of chlorine dioxide radicals responsible for the cleaning. The ratio of these acids is advantageously 1ᵥ: 1ᵥ:1ᵥ.

A stress relief etching can be performed after cleaning and before structuring. This etching can be made with a plasma, for instance an inductively coupled plasma, reactive ion etching ICP/RIE reactor, so as to remove a thin layer, e.g. between 3 and 5 µm, on the face that is to be structured.

The diamond substrate can be placed on a silicon chip and attached thereto by gluing. It can then be nitrogen ion implanted in an ion implanter and thereafter be annealed, e.g. at a temperatures of at least 400°C, preferably 900°C, during at least 100 minutes.

Figure 1 is a schematic illustration of a step of depositing an adhesion layer on the diamond substrate, for instance by electron beam assisted physical vapour deposition (PVD). To that end the diamond substrate 2 on the silicon chip 4 is placed in an electron beam evaporator machine 6. A target 8 on an anode 10 is bombarded with an electron beam given off by a charged tungsten filament 12 under high vacuum. The electron beam causes atoms from the target 8 to transform into the gaseous phase. These atoms then precipitate into solid form, coating the upper face of the diamond substrate 2 with a thin layer of the target material 8 on the anode 10, forming the adhesion layer 14. The adhesion layer 14 can show a thickness of at least 1 nm, preferably 10nm and/or not greater than 200nm, preferably 50nm. The target 8 is made of non-metallic compound. That deposition step has been carried with a polycrystalline silicon target.

Figure 2 is a schematic illustration of a coating step of a resist layer 16 on the adhesion layer 14 of the diamond substrate 4. That coating is for instance made by spin coating in a spin coating machine 18. The resist is for instance hydrogen silsesquioxane HSQ commercially available under the name FOX^{®}-16 of the company Dow Corning^{®}. The diamond substrate can be pre-heated up to 10 minutes at 120° to remove any possible moisture from the surface. The HSQ resist is poured on the centre of the diamond substrate while it is rotating, so as to form the resist layer 14. Optionally, the rotation speed can be varied during or after pouring the resist, e.g. from 1000 rpm to 3300 rpm. Also optionally, the diamond substrate 2 and the silicon chip 4 are post-heated, e.g. at 90°C during 5 minutes.

Figures 3 and 4 are schematic illustrations of removing parts of the resist layer so as to form a structuring mask.

In figure 3, the diamond substrate 2 on the silicon chip 4 is placed in an electron beam lithography (EBL) machine 20. A focused beam of electrons 22 is scanned over the resist layer 16 to draw or write custom shapes on the resist layer. The electron beam changes the solubility of the resist, enabling selective removal of either the exposed or non-exposed regions of the resist by immersing it in a solvent (developing).

After the EBL writing of the resist layer, the diamond substrate is developed by immersion in a solvent. For instance, the diamond substrate (with the silicon chip) can be immersed in a solution comprising tetramethylammonium hydroxide (TMAH), e.g. at 25%, for a duration of at least 10 seconds. It can then be immersed into ultrapure water, and thereafter several times in acetone and afterwards in isopropyl alcohol until the non-exposed regions are totally removed.

In figure 4, shows the diamond substrate 2 with the remaining resist layer 16 further to EBL and development, forming then a structuring mask 24.

Figure 5 illustrates schematically a step of etching the adhesion layer 14 and the diamond material through the structuring mask 24. This is done by reactive-ion etching (RIE), i.e. a chemically reactive plasma under low pressure (vacuum) by an electromagnetic field where high-energy ions from the plasma attack the substrate and react with it. For instance, the diamond substrate 2 and the silicon chip 4 are placed in a plasma machine or installation 26. The latter comprises a chamber supplied with gas and provided with two electrodes 26.1 and 26.2 supplied with an oscillating electrical power supply 26.3. The resulting oscillating electric field ionizes the gas molecules by stripping them of electrons, creating a plasma. The reactive-ion etching can be combined with an inductively coupled plasma (ICP). The ICP is employed as a high density source of ions which increases the etch rate, whereas a separate oscillating electric field bias is applied to the substrate to create directional electric fields near the substrate to achieve more anisotropic etch profiles.

For instance, the etching step is achieved in two sub-steps, namely a first sub-step of removal of the adhesion layer 14 by reactive ions of SF₆ etching through the structuring mask 24, followed by a second sub-step of etching through the structuring mask 24 the material of the diamond substrate by reactive ions of O₂.

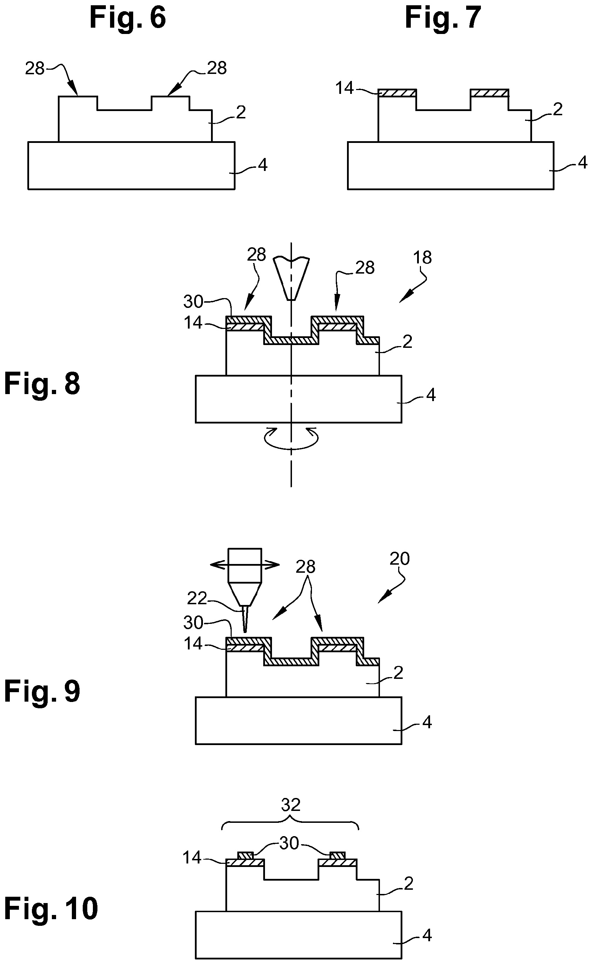

Figure 6 illustrates the diamond substrate 2 on the silicon chip 4 where the structuring mask 24, formed by the resist layer 14, and the adhesion layer 14 have been removed. The resist layer 14 can be removed by immersing the diamond substrate 2 in a chemically etching substance like a hydrogen fluoride (HF) based buffered oxide etch (BOE). The adhesion layer 14 can be removed afterwards by immersing the diamond substrate in a potassium hydroxide solution.

Figures 7 to 11 shows additional steps for further structuring the diamond substrate, following the step of etching the adhesion layer and the diamond material through the structuring mask as in figure 5.

Figure 7 illustrates the diamond substrate 2 on the silicon chip 4 where the structuring mask 24, formed by the resist layer 16, has been removed whereas the remaining adhesion layer 14 is left. This can be achieved chemical etching, e.g. by immersing the diamond substrate 2 in a chemically etching substance like a hydrogen fluoride (HF) based buffered oxide etch (BOE).

Figure 8 illustrates schematically a coating step of a further resist layer 30 on the remaining adhesion layer 14 and also directly on the diamond substrate 4. The absence of adhesion layer between the structures 28 is not an issue because the portion of the further resist layer 30 located between the structures 28 will be removed when forming a further structuring mask (see figure 10). That coating is for instance made by spin coating in a spin coating machine 18 similar or identical to the one in figure 2. The resist is for instance Hydrogen silsesquioxane HSQ available under the commercial name FOX^{®}-16 of the company Dow Corning^{®}. It is referred to the description of figure 2 for further details about this step.

Figures 9 and 10 are schematic illustrations of removing parts of the remaining resist layer 14 on the structures 28 so as to form a further structuring mask 32.

In figure 9, the further resist layer 30 coated in figure 8 is subject to lithography on the structures 28 for drawing or writing custom shapes on the structures 28. For instance, an electron beam 22 is applied in a controlled manner for locally changing the solubility of the further resist. This is done with the same or similar electron beam lithography machine 20 as in figure 3.

After the lithography writing of the further resist layer, the diamond substrate is developed by immersion in a solvent. The diamond substrate (with the silicon chip) can be immersed in a solution comprising tetramethylammonium hydroxide (TMAH), e.g. at 25%, for a duration of at least 10 seconds. It can then be immersed into ultrapure water, and thereafter several times in acetone and afterwards in isopropyl alcohol until the non-exposed regions are totally removed.

Figure 10 shows the diamond substrate 2 with the remaining further resist layer 30 after lithography and development, forming then the further structuring mask 32.

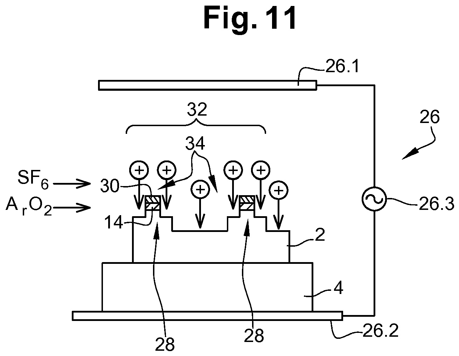

Figure 11 illustrates schematically a step of etching the adhesion layer 14 on the structures 28 through the further structuring mask 32 and the diamond material. This is done by reactive-ion etching (RIE) similarly or identically to the step illustrated in figure 5. The reactive-ion etching step comprises then a first sub-step of etching the remaining adhesion layer 14 on the structures 28, e.g. by SF₆ ions, and a second sub-step of etching the material of the diamond substrate with O₂ ions forming a further structuring 34 on the structures 28.

The further structuring process which has been described in relation with figures 7 to 11 can be carried out several times, in particular when after etching the adhesion layer and the material of the diamond substrate through the last structuring mask, only the structuring mask is removed so as to leave the adhesion layer on the corresponding structures. That left adhesion layer can then be further used for coating a next further resist layer.

The reliability of this plasma transfer and further cleaning process and its influence on shallowly (10-15 nm) implanted colour centres in diamond was evaluated by means of optically detected magnetic resonance (ODMR). Negatively charged nitrogen vacancies, NV(-) possess electronic spin and exhibit a resonance at 2.87 GHz, which can be perceived as a fingerprint of this colour centre. The experimentally obtained ODMR spectrum and photoluminescence map based on nano-pillars of 200 nm diameter etched into the diamond by the method presented here show that the adhesion layer is totally removed and also that there is no bleaching after longer irradiation times, indicating no surface damage and therefore no alternation in the electronic structure of shallowly underlying nitrogen vacancy. This conclusion can be directly related to the reliability of the presented method and perfect adhesion of the tone resist.

## Claims

1. Process of structuring a diamond substrate (2), comprising the steps of:
(a) depositing an adhesion layer (14) on a face of the diamond substrate (2);
(b) coating a resist layer (16) on the adhesion layer (14);
(c) removing parts of the resist layer (16) so as to expose parts of the adhesion layer and form a corresponding structuring mask (24);
(d) etching the adhesion layer (14) and the diamond substrate (2) through the structuring mask (24) so as to form structures (28) on the face of said diamond substrate (2);
wherein the adhesion layer (14) comprises substantially a non-metallic compound; and
**characterized in that** at least one of the structures (28) comprises one or more colour centres.

2. Process according to claim 1, wherein the non-metallic compound comprises at least one of the following list: silicon, silicon oxide, germanium and germanium oxide, and any combination thereof.

3. Process according to one of claims 1 and 2, wherein at step (a) the adhesion layer (14) is deposited by electron beam physical vapour deposition, plasma activated chemical vapour deposition, thermal deposition or atomic layer deposition.

4. Process according to any one of claims 1 to 3, wherein the adhesion layer (14) extends homogeneously over the whole face of the diamond substrate (2), preferably with a thickness of at least 1nm and/or of not more than 200 nm, preferably at least 10nm and/or not more than 50nm.

5. Process according to any one of claims 1 to 4, wherein step (d) comprises the following sub-steps:
(d1) etching the adhesion layer (14) through the structuring mask (24) so as to expose parts of the diamond substrate (2); and
(d2) etching the diamond substrate (2) through the structuring mask (24) so as to structure said diamond substrate.

6. Process according to claim 5, wherein steps (d1) and (d2) are achieved by plasma, preferably with reactive gases, preferably in the same plasma installation (26).

7. Process according to claim 6, wherein the reactive gases in step (d1) is fluorine-based and/or the reactive gas in step (d2) is oxygen based.

8. Process according to any one of claims 1 to 7, wherein the resist layer (16) is an electron beam resist layer or a photo resist layer and step (c) is achieved by electron beam lithography (20) or optical lithography, and subsequent development of the resist.

9. Process according to any one of claims 1 to 8, wherein the resist layer (16) comprises a silsesquioxane, preferably Hydrogen silsesquioxane HSQ.

10. Process according to any one of claims 1 to 9, comprising the further step of:
(e1) removing the structuring mask (24) and the adhering layer (14) that remains further to step (d).

11. Process according to any one of claims 1 to 9, comprises the further steps of:
(e2) removing the structuring mask (24) so that the adhesion layer (14) remains on the structures (28);
(f) coating a further resist layer (30) on the adhesion layer (14) remaining on the structures (28);
(g) removing parts of the further resist layer (30) so as to expose parts of the adhesion layer (14) on the structure (28) and form a further structuring mask (32);
(h) etching the adhesion layer (14) and the diamond substrate (2) through the further structuring mask (32) so as to further structure (34) the structures (28) of said diamond substrate (2).

12. Process according to claim 11, wherein step (h) comprises the following sub-steps:
(h1) etching the adhesion layer (14) through the further structuring mask so as to expose parts of the structures (28) of the diamond substrate (2); and
(h2) etching the diamond substrate (2) through the further structuring mask (32) so as to further structure (34) said diamond substrate (2).

13. Process according to claim 10 or one of claims 11 and 12, wherein step (e1) or (e2) is achieved by wet etching.

14. Process according to any one of claims 1 to 13, wherein the structures (28) comprise structures with a height of at least 1nm, preferably at least 200 nm, and/or of not more than 10 000 nm, preferably not more than 500nm.

15. Process according to any one of claims 1 to 14, wherein at least one of the structures (28) comprise nitrogen-vacancy centres.

## Patentansprüche

1. Verfahren zum Strukturieren eines Diamantsubstrats (2), das die folgenden Schritte umfasst:
(a) Aufbringen einer Haftschicht (14) auf eine Fläche des Diamantsubstrats (2);
(b) Aufbringen einer Abdeckschicht (16) auf die Haftschicht (14);
(c) Entfernen von Teilen der Abdeckschicht (16), um Teile der Haftschicht freizulegen und eine entsprechende Strukturierungsmaske (24) zu bilden;
(d) Ätzen der Haftschicht (14) und des Diamantsubstrats (2) durch die Strukturierungsmaske (24), um Strukturen (28) auf der Fläche des Diamantsubstrats (2) zu bilden;
wobei die Haftschicht (14) im Wesentlichen eine nichtmetallische Verbindung umfasst; und
**dadurch gekennzeichnet, dass** mindestens eine der Strukturen (28) ein oder mehrere Farbzentren umfasst.

2. Verfahren nach Anspruch 1, wobei die nichtmetallische Verbindung mindestens eine der folgenden Verbindungen umfasst: Silizium, Siliziumoxid, Germanium und Germaniumoxid und eine beliebige Kombination davon.

3. Verfahren nach einem der Ansprüche 1 und 2, wobei in Schritt (a) die Haftschicht (14) durch physikalische Elektronenstrahl-Dampfabscheidung, plasmaaktivierte chemische Dampfabscheidung, thermische Abscheidung oder Atomlagenabscheidung abgeschieden wird.

4. Verfahren nach einem der Ansprüche 1 bis 3, wobei sich die Haftschicht (14) homogen über die gesamte Fläche des Diamantsubstrats (2) erstreckt, vorzugsweise mit einer Dicke von mindestens 1 mm und/oder von nicht mehr als 200 nm, vorzugsweise mindestens 10 nm und/oder nicht mehr als 50 nm.

5. Verfahren nach einem der Ansprüche 1 bis 4, wobei Schritt (d) die folgenden Teilschritte umfasst:
(d1) Ätzen der Haftschicht (14) durch die Strukturierungsmaske (24), um Teile des Diamantsubstrats (2) freizulegen; und
(d2) Ätzen des Diamantsubstrats (2) durch die Strukturierungsmaske (24), um das Diamantsubstrat zu strukturieren.

6. Verfahren nach Anspruch 5, wobei die Schritte (d1) und (d2) durch Plasma, vorzugsweise mit reaktiven Gasen, vorzugsweise in derselben Plasmaanlage (26), erreicht werden.

7. Verfahren nach Anspruch 6, wobei die reaktiven Gase in Schritt (d1) auf Fluor basieren und/oder das reaktive Gas in Schritt (d2) auf Sauerstoff basiert.

8. Verfahren nach einem der Ansprüche 1 bis 7, wobei die Abdeckschicht (16) eine Elektronenstrahlabdeckschicht oder eine Photoabdeckschicht ist und Schritt (c) durch Elektronenstrahllithographie (20) oder optische Lithographie und anschließende Entwicklung des Abdeckmittels erreicht wird.

9. Verfahren nach einem der Ansprüche 1 bis 8, wobei die Abdeckschicht (16) ein Silsesquioxan, vorzugsweise Hydrogensilsesquioxan HSQ, umfasst.

10. Verfahren nach einem der Ansprüche 1 bis 9, umfassend den weiteren Schritt:
(e1) Entfernen der Strukturierungsmaske (24) und der Haftschicht (14), die nach Schritt (d) verbleibt.

11. Verfahren nach einem der Ansprüche 1 bis 9, umfassend die weiteren Schritte:
(e2) Entfernen der Strukturierungsmaske (24), so dass die Haftschicht (14) auf den Strukturen (28) verbleibt;
(f) Auftragen einer weiteren Abdeckschicht (30) auf die auf den Strukturen (28) verbliebene Haftschicht (14);
(g) Entfernen von Teilen der weiteren Abdeckschicht (30), um Teile der Haftschicht (14) auf der Struktur (28) freizulegen und eine weitere Strukturierungsmaske (32) zu bilden;
(h) Ätzen der Haftschicht (14) und des Diamantsubstrats (2) durch die weitere Strukturierungsmaske (32), um die Strukturen (28) des Diamantsubstrats (2) weiter zu strukturieren (34).

12. Verfahren nach Anspruch 11, wobei Schritt (h) die folgenden Teilschritte umfasst:
(h1) Ätzen der Haftschicht (14) durch die weitere Strukturierungsmaske, um Teile der Strukturen (28) des Diamantsubstrats (2) freizulegen, und
(h2) Ätzen des Diamantsubstrats (2) durch die weitere Strukturierungsmaske (32), um das Diamantsubstrat (2) weiter zu strukturieren (34).

13. Verfahren nach Anspruch 10 oder einem der Ansprüche 11 und 12, wobei Schritt (e1) oder (e2) durch Nassätzen erreicht wird.

14. Verfahren nach einem der Ansprüche 1 bis 13, wobei die Strukturen (28) Strukturen mit einer Höhe von mindestens 1 nm, vorzugsweise mindestens 200 nm, und/oder von nicht mehr als 10.000 nm, vorzugsweise nicht mehr als 500 nm, umfassen.

15. Verfahren gemäß einem der Ansprüche 1 bis 14, wobei mindestens eine der Strukturen (28) Stickstoff-Vakanz-Zentren umfasst.

## Revendications

1. Procédé de structuration d'un substrat en diamant (2), comprenant les étapes suivantes consistant à :
(a) déposer une couche d'adhésion (14) sur une face du substrat en diamant (2) ;
(b) revêtir la couche d'adhésion (14) d'une couche de résistance (16) ;
(c) enlever des parties de la couche de résistance (16) de manière à exposer des parties de la couche d'adhésion et à former un masque de structuration correspondant (24) ;
(d) graver la couche d'adhésion (14) et le substrat en diamant (2) à travers le masque de structuration (24) de manière à former des structures (28) sur la face dudit substrat en diamant (2) ;
dans lequel la couche d'adhésion (14) comprend essentiellement un composé non métallique ; et
**caractérisé en ce qu'**au moins l'une des structures (28) comprend un ou plusieurs centres colorés.

2. Procédé selon la revendication 1, dans lequel le composé non métallique comprend au moins l'un des éléments suivants : silicium, oxyde de silicium, germanium et oxyde de germanium, et toute combinaison de ceux-ci.

3. Procédé selon l'une des revendications 1 et 2, dans lequel, à l'étape (a), la couche d'adhésion (14) est déposée par dépôt physique en phase vapeur par faisceau d'électrons, par dépôt chimique en phase vapeur activé par plasma, par dépôt thermique ou par dépôt par couche atomique.

4. Procédé selon l'une quelconque des revendications 1 à 3, dans lequel la couche d'adhésion (14) s'étend de manière homogène sur toute la surface du substrat en diamant (2), de préférence avec une épaisseur d'au moins 1 nm et/ou d'au plus 200 nm, de préférence d'au moins 10 nm et/ou d'au plus 50 nm.

5. Procédé selon l'une quelconque des revendications 1 à 4, dans lequel l'étape (d) comprend les sous-étapes suivantes consistant à :
(d1) graver la couche d'adhésion (14) à travers le masque de structuration (24) de manière à exposer des parties du substrat en diamant (2) ; et
(d2) graver le substrat en diamant (2) à travers le masque de structuration (24) de manière à structurer ledit substrat en diamant.

6. Procédé selon la revendication 5, dans lequel les étapes (d1) et (d2) sont réalisées par plasma, de préférence avec des gaz réactifs, de préférence dans la même installation de plasma (26).

7. Procédé selon la revendication 6, dans lequel les gaz réactifs utilisés à l'étape (d1) sont à base de fluor et/ou le gaz réactif utilisé à l'étape (d2) est à base d'oxygène.

8. Procédé selon l'une quelconque des revendications 1 à 7, dans lequel la couche de résistance (16) est une couche résistante au faisceau d'électrons ou une couche de résine photosensible et l'étape (c) est réalisée par lithographie par faisceau d'électrons (20) ou par lithographie optique, et développement ultérieur de la couche résistante.

9. Procédé selon l'une quelconque des revendications 1 à 8, dans lequel la couche de résistance (16) comprend un silsesquioxane, de préférence de l'hydrogène silsesquioxane HSQ.

10. Procédé selon l'une quelconque des revendications 1 à 9, comprenant l'étape supplémentaire consistant à :
(e1) enlever le masque de structuration (24) et la couche adhésive (14) qui subsiste après l'étape (d).

11. Procédé selon l'une quelconque des revendications 1 à 9, comprenant les étapes supplémentaires suivantes consistant à :
(e2) enlever le masque de structuration (24) de sorte que la couche d'adhésion (14) reste sur les structures (28) ;
(f) déposer une couche de résistance supplémentaire (30) sur la couche d'adhésion (14) restant sur les structures (28) ;
(g) enlever des parties de la couche de résistance supplémentaire (30) de manière à exposer des parties de la couche d'adhésion (14) restant sur la structure (28) et à former un masque de structuration supplémentaire (32) ;
(h) graver la couche d'adhésion (14) et le substrat en diamant (2) à travers le masque de structuration supplémentaire (32) de manière à structurer davantage (34) les structures (28) dudit substrat en diamant (2).

12. Procédé selon la revendication 11, dans lequel l'étape (h) comprend les sous-étapes suivantes consistant à :
(h1) graver la couche d'adhésion (14) à travers le masque de structuration supplémentaire de manière à exposer des parties des structures (28) du substrat en diamant (2) ; et
(h2) graver le substrat en diamant (2) à travers le masque de structuration supplémentaire (32) de manière à structurer davantage (34) ledit substrat en diamant (2).

13. Procédé selon la revendication 10 ou l'une des revendications 11 et 12, dans lequel l'étape (e1) ou (e2) est réalisée par gravure humide.

14. Procédé selon l'une quelconque des revendications 1 à 13, dans lequel les structures (28) comprennent des structures d'une hauteur d'au moins 1 nm, de préférence d'au moins 200 nm, et/ou d'au plus 10 000 nm, de préférence d'au plus 500 nm.

15. Procédé selon l'une quelconque des revendications 1 à 14, dans lequel au moins une des structures (28) comporte des centres azote-lacune.
